# EUROPEAN PATENT APPLICATION

(11) **EP 3 418 632 A1**
(43) Date of publication of application: **26.12.2018**
(21) Application number: 17753535.8
(22) Date of filing: 17.02.2017
(51) Int. Cl.: F21V 33/00, F21S 9/02, F21V 17/10, F21V 15/01, F21V 14/00, F21V 7/00, H01L 31/04, F21V 27/00, F21V 29/70

(54) **CAMERA-INTEGRATED LED LIGHTING DEVICE**

(30) Priority: 18.02.2016 KR 20160019332
(71) Applicant: KMW Inc., Hwaseong-si, Gyeonggi-do 18462 (KR)
(72) Inventor: KIM, Dukyong, Yongin-si Gyeonggi-do 17086 (KR)
(74) Representative: RatnerPrestia
(86) International application number: PCT/KR2017/001817
(87) International publication number: WO 2017/142374

(57) **Abstract**

The present invention relates to a camera-integrated LED lighting device, comprising: a body unit (200) having a lower surface at which a part of a camera unit (210) is exposed, and having a power supply unit (250) embedded therein; a lighting unit (100) coupled to the front surface of the body unit (200), and including a plurality of LEDs and receiving power provided from the power supply unit (250) of the body unit (200) so as to provide light; a connecting unit (300) arranged on a rear surface of the body unit (200) so as to be coupled to a support or an arm; and a camera protection unit (240) protruding from the lower surface of the body unit (200) along the circumference of the camera unit (210).

## Description

### TECHNICAL FIELD

The present invention relates to a camera-integrated LED lighting device (i.e., an LED lighting device with a camera), and more particularly, to a camera-integrated LED lighting device capable of preventing illumination light from being directly incident on a camera while meeting safety standards.

### BACKGROUND ART

In recent years, LED products have been developed to replace existing lighting such as street lights or indoor lights since LEDs generally have characteristics such as longer life and lower power consumption compared to the existing lighting.

In particular, efforts have been made to provide multifunctional lighting devices having security functions through cameras added thereto, and the like, in addition to simple illumination functions.

For example, there is Korean Patent No. 10-1083606 (registered on November 19, 2011, entitled "LED LIGHTING DEVICE INSTALLED WITH CAMERA MODULE") in which a camera module is installed inside an LED module. In this patent document, it is difficult to photograph and recognize an actual area to be captured because the light emitted from the LED module is directly incident on the camera module.

That is, an area to be captured interferes with light because the light emitted from LEDs should be reflected from the area to be captured and then be incident on a camera, but it is directly incident on the camera.

In order to resolve this issue, the LED module and the camera module may be formed to be separated from each other. However, it is difficult to prevent light from being directly incident from the LED module on the camera module and the camera module is more likely to be damaged by external shock because it protrudes. In the case where the LED lighting device is especially installed where sandstorms blow, the maintenance of the camera module costs a lot of money since the camera module is damaged with frequency.

Meanwhile, a street light required for high-level safety in the United States is determined to fail for safety reasons if moisture forms in the vicinity of power supply lines through exposure experiments in the external environment. In addition, a camera is required to be completely isolated from the exterior and interior circuit parts of a device in the United States. Accordingly, it is necessary to develop a camera-integrated LED lighting device that meets the safety standards in the United States.

Moreover, a camera module and an LED module are conventionally installed in the same casing. Hence, there is a problem in that the maintenance of the camera module and the LED module is not easy because both should be collected and repaired even when one of them is damaged.

### DISCLOSURE

### TECHNICAL PROBLEM

The present invention has been made in view of the above-mentioned problems, and an object thereof is to provide a camera-integrated LED lighting device capable of preventing light from being directly incident from an LED lighting unit on a camera.

In addition, another object of the present invention is to provide a camera-integrated LED lighting device capable of preventing damage on a camera from external influences.

In addition, still another object of the present invention is to provide a camera-integrated LED lighting device capable of meeting safety standards in the United States.

In addition, a further object of the present invention is to provide a camera-integrated LED lighting device that enables a main body having a camera installed therein and a lighting unit to be easily connected to and disconnected from each other.

### TECHNICAL SOLUTION

In accordance with an aspect of the present invention, a camera-integrated LED lighting device includes a main body (200) having a power supply (250) built therein, a portion of a camera module (210) being exposed at a bottom surface of the main body (200), a lighting unit (100) coupled to a front surface of the main body (200) and including a plurality of LEDs to provide illumination by power supplied from the power supply (250) of the main body (200), a connection unit (300) arranged on a rear surface of the main body (200) for coupling with a support or an arm, and a camera protector (240) protruding from the bottom surface of the main body (200) along the circumference of the camera module (210).

The camera-integrated LED lighting device may include a light shielding plate (220) arranged at a portion of the bottom surface of the main body (200) to block direct introduction of light from the lighting unit (100) to the camera module (210).

The light shielding plate (220) may be installed to be inclined such that its lower end is directed downward of the lighting unit (100) in a state in which an upper end of the light shielding plate (220) is coupled to the bottom surface of the main body (200).

The light shielding plate (220) may be used as a reflective surface, a light absorption surface, or a solar cell.

The main body (200) may include a lower housing (280) that is open at its upper portion to accommodate the camera module (210), the power supply (250), a communication module (260), and a control circuit (270) therein, an inner cover (281) that covers the upper portion of the lower housing (280) and has a resin antenna protection cap (283) positioned above an antenna (261) of the communication module (260), and an outer cover (282) coupled to the upper surface of the inner cover (281) to prevent introduction of moisture thereinto.

The lower housing (280) may include a hole (285) for insertion of the camera module (210), and may further include a separator (211) covering the hole (285) when the camera module (210) is inserted into the hole (285).

The connection unit (300) may allow an electric wire to be connected from the outside to the power supply (250) of the main body (200), and may include a wire cover (310) to prevent exposure of the electric wire.

The lighting unit (100) may include a casing (110) having a light outlet (111) and a plurality of seating surfaces formed on a portion of its inner surface, a plurality of substrates (121 and 122) seated on the respective seating surfaces, the LEDs being mounted on each of the substrates (121 and 122), and a plurality of radiation parts disposed at respective portions on an outer surface of the casing (110) corresponding to the seating surfaces positioned on the inner surface of the casing (110) so that each of the radiation parts dissipates heat from an associated one of the substrates (121 and 122).

The camera-integrated LED lighting device may further include a hinge unit (1000) connecting the lighting unit (100) to the main body (200), wherein the hinge unit (1000) may include a fixing part including a hollow tubular body, coupled to a connection pipe (290) provided from the main body (200), and a cylindrical body having a first opening that is open at one surface thereof and a closed surface closed at the other surface thereof, a rotating part including a rotating body rotatably assembled to an outer surface of the cylindrical body, the rotating body having a coupler formed on its outer surface corresponding to a second opening formed to be open at the outer surface of the cylindrical body, the coupler being coupled to a connection pipe (119) provided from the lighting unit (100), so that the rotating part is coupled to the lighting unit (100), and a rotation support part including first and second support plates assembled to both edges of the rotating body to cover the closed surface and the first opening of the cylindrical body, the respective first and second support plates having first and second arc guide holes for arrangement of first and second fixing shafts provided at both edges of the cylindrical body 1110b, so that the rotation support part supports rotational movement of the rotating body relative to the cylindrical body.

The camera-integrated LED lighting device may further include a hinge unit (1000) connecting the lighting unit (100) to the main body (200), wherein the hinge unit (1000) may include a fixing part including a hollow tubular body, coupled to a connection pipe (290) provided from the main body (200), and a cylindrical body having a first opening that is open at one surface thereof and a closed surface closed at the other surface thereof, a rotating part including a rotating body rotatably assembled to an outer surface of the cylindrical body, the rotating body having a coupler formed on its outer surface corresponding to a second opening formed to be open at the outer surface of the cylindrical body, the coupler being coupled to a connection pipe (119) provided from the lighting unit (100), so that the rotating part is coupled to the lighting unit (100), and a rotation support part including first and second support plates assembled to both edges of the rotating body to cover the closed surface and the first opening of the cylindrical body, the respective first and second support plates having first and second arc guide holes for arrangement of first and second fixing shafts provided at both edges of the cylindrical body 1110b, so that the rotation support part supports rotational movement of the rotating body relative to the cylindrical body. In an internal space of the cylindrical body, an electric wire provided from the main body (200) may be connected to an electric wire provided from the lighting unit (100).

One of the first and second fixing shafts may be a screw member for rotation guide, which is screwed to a coupling hole formed at an outer edge of the cylindrical body to be disposed in an associated one of the arc guide holes of the first and second support plates.

The cylindrical body may include a thick portion in which the coupling hole coupled with the fixing shaft is formed.

The other of the first and second fixing shafts may be a pin member for rotation guide and position check, which protrudes from the closed surface of the cylindrical body to be disposed in an associated one of the arc guide holes of the first and second support plates.

An indicator may be provided at an outer edge of the arc guide hole to check a change in position of the pin member for rotation guide and position check.

The closed surface of the cylindrical body may be formed with a recessed shaft hole for assembly of a rotation support shaft coupled through a central hole formed at the center of the second support plate.

The coupler may have an extension rib extending outward to increase coupling force with the connection pipe when the coupler is coupled with the lighting unit.

A junction part may be provided in an internal space of the cylindrical body to electrically connect a first cable provided from the main body (200) to a second cable provided from the lighting unit (100), and the junction part may include a base plate having a junction substrate mounted thereon, an end of the first cable being electrically connected to an end of the second cable on the junction substrate.

The base plate may be an integral plate extending outward from an inner surface of the cylindrical body, or a detachable plate assembled in such a manner that one end thereof is inserted into an assembly groove of an assembly jaw formed on the inner surface of the cylindrical body.

### ADVANTAGEOUS EFFECTS

A camera-integrated LED lighting device of the present invention includes a main body having a lighting unit coupled to the front surface thereof while a camera is exposed at the bottom surface of the main body, and further includes a light shielding plate arranged at a portion of the bottom surface of the main body between the lighting unit and the camera to prevent light from being directly incident from the lighting unit to the camera, thereby enabling the image of an area to be captured to be prevented from interfering with the light emitted from the lighting unit.

In addition, the camera-integrated LED lighting device of the present invention includes a camera protector that protrudes from the bottom surface of the main body along the circumference of the camera for maximum protection of the camera from external influences, and it is thus possible to prevent the damage of the camera due to external influences.

In addition, the camera-integrated LED lighting device of the present invention can meet safety standards in the United States since the camera is installed to be separated from the internal components of the main body as well as the outside, and the exposure of electric wires is prevented from moisture in a connection unit allowing the main body to be connected to a support or an arm.

Furthermore, the camera-integrated LED lighting device of the present invention is configured such that the main body and the lighting unit can be decoupled from each other, the angle of the lighting unit is adjustable by a hinge connection part, and the connection between the main body and the lighting unit can be easily performed.

### BRIEF DESCRIPTION OF DRAWINGS

Fig. 1 is an assembled perspective view illustrating a camera-integrated LED lighting device according to a preferred embodiment of the present invention.
Fig. 2 is an exploded perspective view of Fig. 1.
Fig. 3 is a partially cut perspective view of the back side of Fig. 1.
Fig. 4 is an exploded perspective view illustrating a lighting unit.
Fig. 5 is a schematic view illustrating a casing in the lighting unit.
Figs. 6 and 7 are side perspective views illustrating a hinge unit when viewed from the different sides.
Figs. 8 and 9 are exploded perspective views of Figs. 6 and 7, respectively.
Figs. 10 and 11 are cross-sectional views of Figs. 6 and 7, respectively.
Fig. 12 a schematic view illustrating application of a junction part in the direction of Fig. 6.

### BEST MODE FOR INVENTION

Hereinafter, a camera-integrated LED lighting device of the present invention will be described in detail with reference to the accompanying drawings.

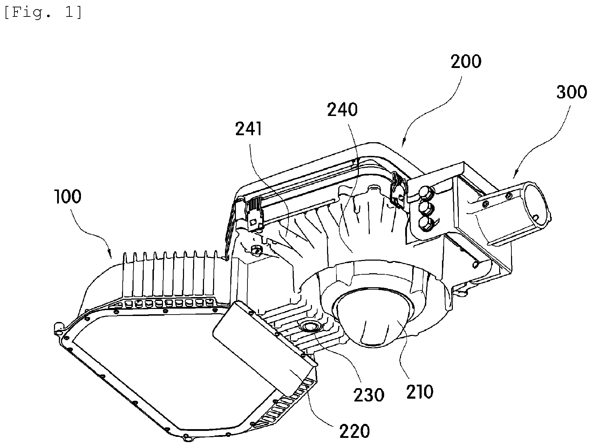

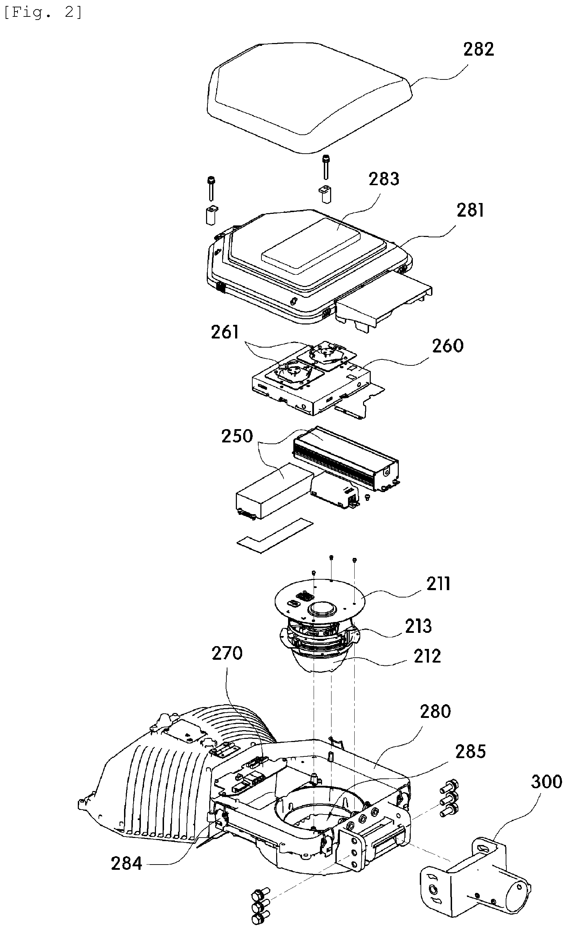

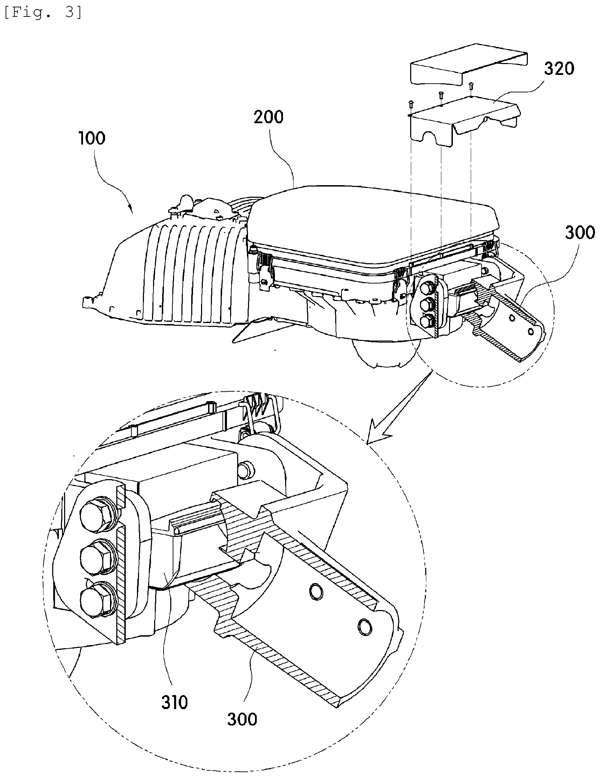

Fig. 1 is an assembled perspective view illustrating a camera-integrated LED lighting device according to a preferred embodiment of the present invention. Fig. 2 is an exploded perspective view of Fig. 1. Fig. 3 is a partially cut perspective view of the back side of Fig. 1.

Referring to Figs. 1 to 3, the camera-integrated LED lighting device according to the preferred embodiment of the present invention includes a main body 200 that has a power supply 250 built therein while a portion of a camera module 210 is exposed at the bottom surface of the main body 200, a lighting unit 100 that is coupled to the front surface of the main body 200 and includes a plurality of LEDs to provide illumination by power supplied from the power supply 250 of the main body 200, a connection unit 300 arranged on the rear surface of the main body 200 for coupling with a support or an arm, and a light shielding plate 220 arranged at a portion of the bottom surface of the main body 200 to block the introduction of light from the lighting unit 100 to the camera module 210.

The configuration and operation of the camera-integrated LED lighting device according to the preferred embodiment of the present invention having the above structure will be described in more detail below.

First, a portion of the camera module 210 is exposed at the bottom surface of the main body 200, and the light shielding plate 220 protrudes from the bottom surface of the main body 200, which is adjacent to the lighting unit 100 coupled to the front surface of the main body 200, to prevent the direct introduction of light from the lighting unit 100 to the camera module 210.

The light shielding plate 220 has a square plate shape. The upper end of the light shielding plate 220 is fixedly coupled to the main body 200 and the lower end thereof extends downward, thereby enabling light to be prevented from being directly introduced from the lighting unit 100 to the camera module 210.

In this case, the light shielding plate 220 may serve to reflect the light emitted from the lighting unit 100 by setting the surface of the light shielding plate 220 facing the lighting unit 100 as a reflective surface, or may be configured to convert a portion of light, which does not affect light distribution, into electrical energy in such a manner that it is made of a light absorption material or is used as a solar cell panel.

Especially, the light shielding plate 220 may be installed to be inclined at an angle other than perpendicular to the bottom surface of the main body 200 in the state in which the upper end of the light shielding plate 220 is coupled to the bottom surface of the main body 200. In this case, the light shielding plate 220 is inclined such that the lower end thereof 220 is directed toward the lower portion of the lighting unit 100.

This inclination direction of the light shielding plate 220 prevents a driver or a pedestrian from being dazzled by light reflected from the light shielding plate 220 in the case where the light shielding plate 220 is used as a reflective surface, and allows photoelectric efficiency to be further enhanced in the case where the light shielding plate 220 is used as a solar cell.

The main body 200 includes a motion sensor 230 installed on the bottom surface thereof. The motion sensor 230 may be configured to be interlocked with the lighting unit 100 or the camera module 210 or to be simultaneously interlocked with the lighting unit 100 and the camera module 210.

That is, each of the lighting unit 100 and the camera module 210 may selectively perform lighting or photographing only when movement is detected by the motion sensor 230, without always performing it.

The main body 200 includes a camera protector 240 that is arranged on the bottom surface thereof to protrude downward along the circumference spaced apart from the camera module 210 by a predetermined distance. The camera protector 240 may be formed integrally with the main body 200, and may be configured to have a maximum height that does not interfere with an angle of view of a camera built in the camera module 210, thereby preventing the breakage or damage of the camera module 210 from external influences.

The main body 200 has radiation fins 241 radially formed throughout the bottom surface thereof outside the camera protector 240.

The main body 200 includes the power supply 250, a communication module 260, and a control circuit 270 that are built therein. The communication module 260 may be a mobile communication base station or a near-field communication module, and may transmit image data photographed by the camera module 210 to the outside.

The main body 200 may include a lower housing 280 that accommodates the power supply 250, the communication module 260, and the control circuit 270 therein, an inner cover 281 that covers the lower housing 280, and an outer cover 282 that covers the upper surface of the inner cover 281 to block the introduction of moisture thereinto.

The inner cover 281 may be provided with an antenna protection cap 283 that is positioned above an antenna 261 of the communication module 260. The antenna protection cap 283 may be made a resin material such that the wireless communication of the communication module 260 functions smoothly, and the inner cover 281 may be made of a metal material.

In addition, the outer cover 282 may be made of a resin material to block the introduction of moisture therein while preventing an occurrence of communication jamming due to metal during wireless communication. The inner cover 281 may have a latch formed at the bottom surface thereof so that the upper portion of the communication module 260 accommodated in the lower portion of the device is fixedly fitted into the latch.

The lower housing 280 has locking members 284 that are spaced apart from each other by a predetermined distance at the side thereof to lock or unlock the inner cover 281 with simple operation. The inspection and maintenance of components accommodated in the main body 200 are facilitated by the locking members 284.

The lower housing 280 has a hole 285 formed in the bottom surface thereof so that a portion of the camera module 210 may protrude to the bottom surface of the main body 200 through the hole 285. The camera module 210 includes a camera accommodation part 213 accommodating the camera therein and a cap 212 coupled to the lower portion of the camera accommodation part 213 to protect the camera, in which case the assembled camera module 210 may does not meet safety standards in the United States since the camera is determined to be disposed in the same space as the power supply 250 or the like.

Considering this point, the space is divided into a space in which the camera is disposed and a space in which the power supply 250 is disposed by covering the hole 285 with the use of a separator 211 coupled to the upper portion of the camera accommodation part 213. The separator 211 is set to have a diameter greater than the hole 285 so that the lower edge of the separator 211 may be fixed by bolts or the like in the state in which it is in contact with the bottom surface of the lower housing 280 around the hole 285.

Since the space in which the camera is disposed is separated from the internal space of the main body 200 in which other electrical components are accommodated as described above, it is possible to provide a device that meets the safety standards in the United States.

Although the camera module 210 is illustrated as being coupled into the hole 285 from top to down in the drawings, the camera accommodation part 213 is coupled into the hole 285 from down to top and then coupled to the separator 211 in the state in which the separator 210 and camera accommodation part 213 of the camera module 210 are decoupled from each other. Thus, it is possible to perform replacement or maintenance by decoupling the camera module 210 without opening the inner cover 281.

The connection unit 300 is coupled to the rear surface of the lower housing 280. The connection unit 300 allows the device of the present invention to be coupled to the support or the arm, and the electric wires provided from the support or the arm are connected to the power supply 250 in the main body 200 through the inside of the connection unit 300.

In this case, the connection unit 300 further includes a wire cover 310 to cover the electric wires connected through the inside of the connection unit 300. Only an upper cover 320 is typically used to prevent the introduction of rainwater between the connection unit 300 and the main body 200, but the separate wire cover 310 is further installed to prevent moisture from forming in the vicinity of the electric wires in the lower portion of the device, which is also to provide a product that meets the safety standards in the United States.

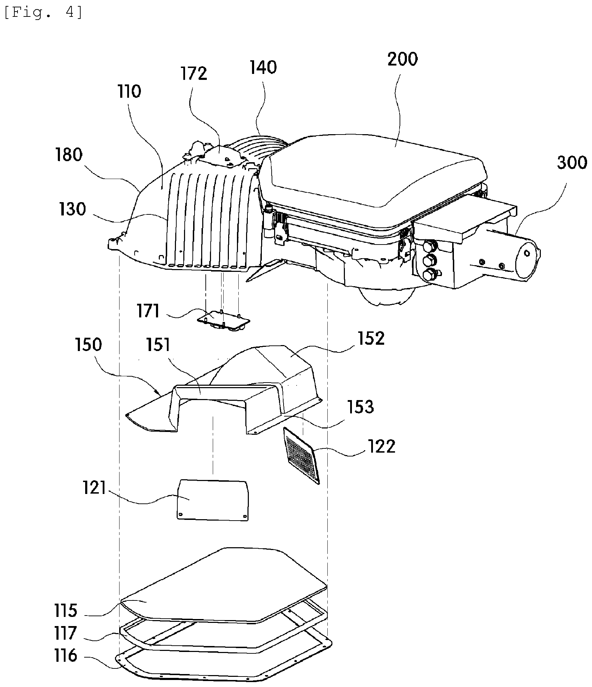

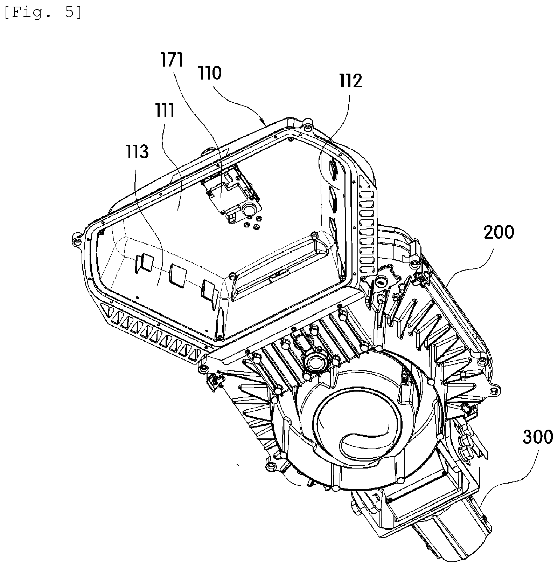

Fig. 4 is an exploded perspective view illustrating the lighting unit 100. Fig. 5 is a schematic view illustrating a casing 110.

Referring to Figs. 4 and 5, the lighting unit 100 includes a casing 110 that has an accommodation space defined therein, a light outlet 111 formed in one surface thereof, and a pair of seating surfaces 112 and 113 spaced apart from each other in the accommodation space, substrates 121 and 122 that are seated on the respective seating surfaces 112 and 113 of the casing 110 while a plurality of LEDs are mounted on each of the substrates 121 and 122, radiation parts 130 and 140 that are respectively disposed outside the casing 110 at the formation positions of the seating surfaces 112 and 113, and a reflector 150 that is inserted into the casing 110 to reflect the light emitted from the substrates 121 and 122 for emission of the reflected light through the light outlet 111.

In Fig. 4, reference numeral 115 refers to a cover that covers the light outlet 111, reference numeral 116 refers to a frame that fixes the cover 115 to the light outlet 111, and reference numeral 117 refers to a packing.

The casing 110 is a component formed integrally. Although the radiation parts 130 and 140 are illustrated as components independently of the casing 110 for convenience of description, but they are formed integrally with the casing 110.

The specific shape of the casing 110 may be changed, and the casing 110 may have any shape as long as the light outlet 111 is formed at one side thereof and a predetermined space is defined above the light outlet 111.

The pair of seating portions 112 and 113 are formed in the casing 110. The seating portions 112 and 113 serve to fix the respective substrates 121 and 122, and the radiation parts 130 and 140 are respectively disposed outside the casing 110 at positions corresponding to the seating portions 112 and 113 within the casing 110 as described above.

The reason the plurality of seating portions 112 and 113 are formed is because, if LEDs are densely arranged on a single substrate for realization of high-power light sources, the densely arranged LEDs radiate high heat, in which case heat radiation efficiency is low when this heat is dissipated from a single radiation part.

In the present invention, the plurality of seating portions 112 and 113 are formed, the LEDs for realization of high power are distributed and mounted on the two substrates 121 and 122, and each of the radiation parts 130 and 140 is disposed to dissipate heat from an associated one of the substrates 121 and 122 to thereby enhance heat radiation efficiency. Thus, since heat is easily dissipated, it is possible to prevent the life shortening of the LEDs.

In order to use the light emitted from the LEDs as illumination, the light emitted through the light outlet 111 has to be adjusted to be distributed suitable for the purpose of the lighting device.

It is relatively easy to distribute the light emitted from LEDs mounted on a single substrate as in the related art, but it is technically very difficult to distribute the light, emitted from LEDs mounted on each of two separated substrates, in a single pattern.

The light, emitted the LEDs mounted on the substrates 121 and 122 fixedly seated on the two spaced seating portions 112 and 113, is reflected from the reflector 150 to be suitably distributed and emitted through the light outlet 111. Here, the suitable distribution of light means light distribution that is limited by regulations or the like. That is, in a street light, it means light distribution pursuant to regulations on an intensity of illumination of a road surface and an irradiation range (area) of light.

The reflector 150 has a single plate shape, and has curved reflective portions 151 and 152, each reflecting the light emitted from an associated one of the substrates 121 and 122. The reflector 150 has a divider 153 disposed between the curved reflective portions 151 and 152 to divide the space therebetween so that the light reflected from each of the curved reflective portions 151 and 152 may not be introduced into an opposite space.

Each of the curved reflective portions 151 and 152 defines a light reflection space that is convex upward from the light outlet 111, and it is possible to adjust the distribution of light emitted from the LEDs according to the curvatures and sizes of the curved reflective portions 151 and 152.

That is, light distribution may be adapted by designing the reflector 150 in the state in which the specifications of the casing 110 and the output specifications of the LEDs are determined. Accordingly, although the specific configuration of the reflector 150 may be changed by other factors determining light distribution, the configuration of the reflector 150 may be consistent in that the number of curved reflective portions 151 and 152 must basically correspond to the number of substrates 121 and 122 and the divider 153 must be positioned between the reflection spaces defined by the respective curved reflective portions 151 and 152.

The casing 110 has an illumination sensor 172 that enables an intensity of illumination to be adjusted by controlling the power supplied from the power supply 250 to the substrates 121 and 122 according to the external illuminance, and has a communication element 171 that enables various types of control to be performed while communicating with the outside.

Although the lighting unit 100 and the main body 200 of the present invention are described as being formed integrally with each other, they may be separated from each other, in which case the replacement or maintenance thereof is easy compared to that of the integrated lighting unit 100 and main body 200.

That is, when any LED of the lighting unit 100 is damaged, it is possible to replace or repair it by decoupling the lighting unit 100. This can ensure the safety of work since only the lighting unit 100 is easily decoupled without a need to treat the entire heavy device, especially in high place work.

In addition, it is difficult to adjust an angle of only the lighting unit 100 in the case where the lighting unit 100 and the main body 200 are formed integrally with or directly coupled to each other. However, it is possible to adjust an angle of the lighting unit 100, in the state in which the main body 200 is fixed to the support or the arm, with the use of a hinge unit proposed in the present invention.

Hereinafter, a hinge unit 1000 which may be applied to the present invention will be described in more detail.

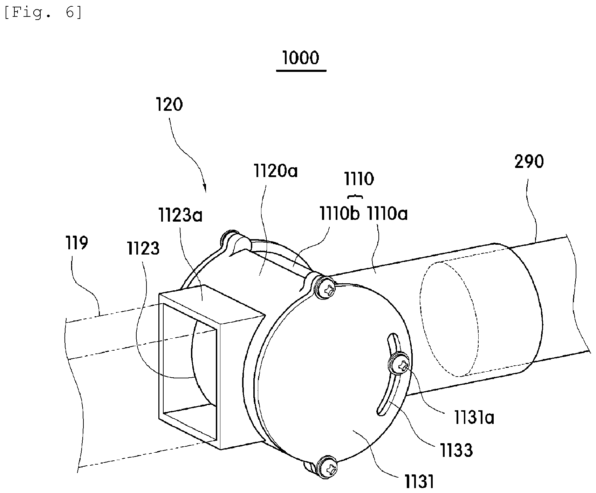

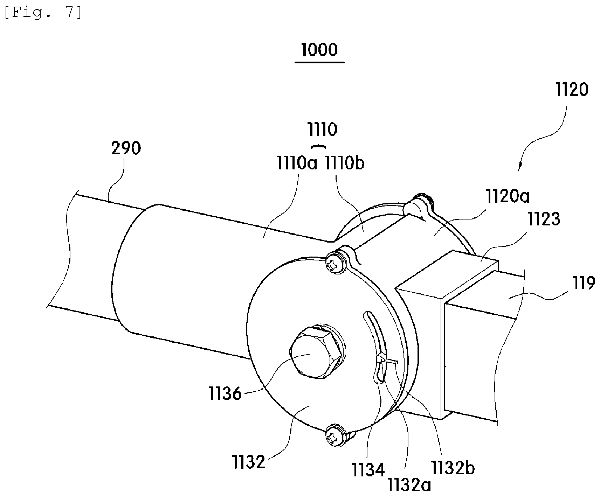

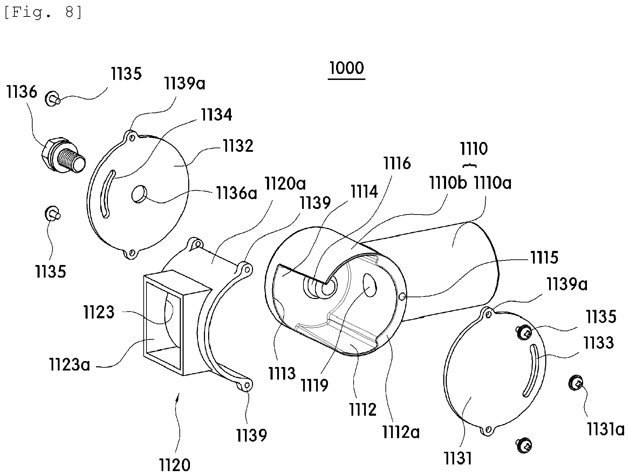

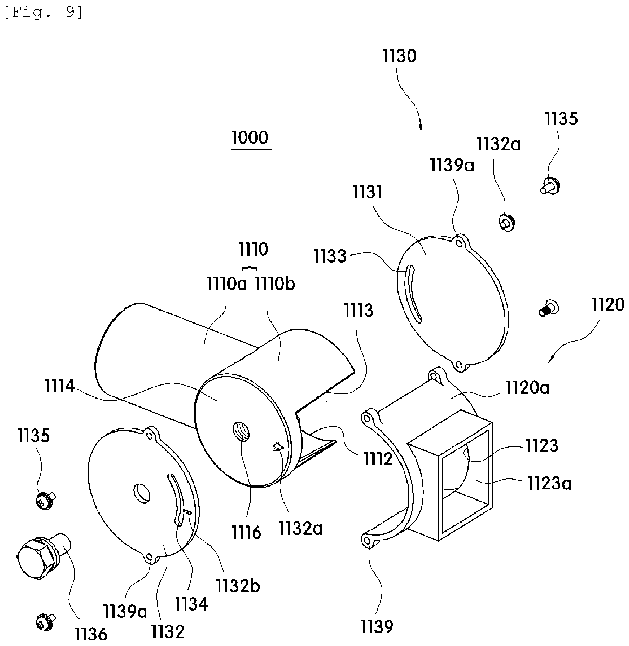

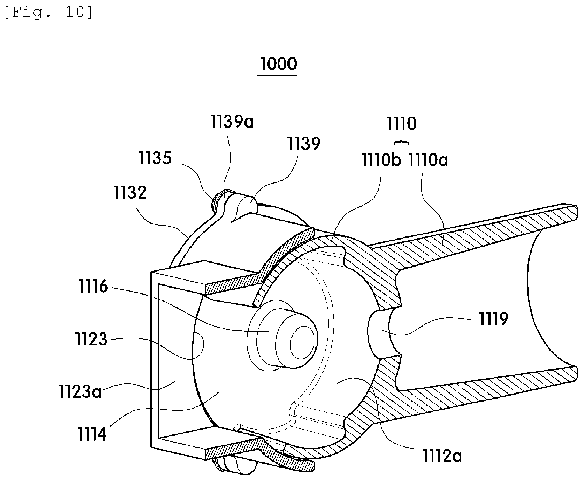

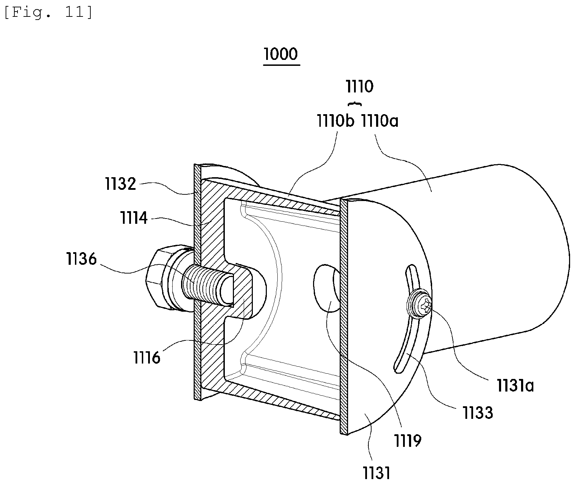

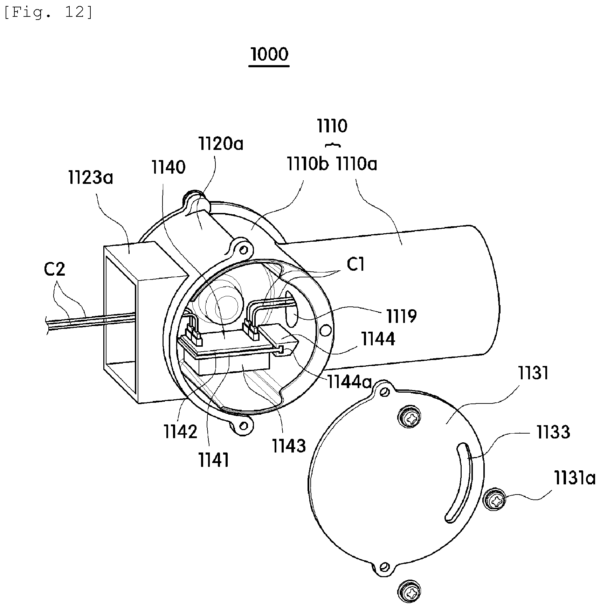

Figs. 6 and 7 are side perspective views illustrating the hinge unit 1000 when viewed from the different sides. Figs. 8 and 9 are exploded perspective views of Figs. 6 and 7, respectively. Figs. 10 and 11 are cross-sectional views of Figs. 6 and 7, respectively. Fig. 12 a schematic view illustrating application of a junction part in the direction of Fig. 6.

Referring to Figs. 6 to 12, the hinge unit 1000 applied to the present invention includes a fixing part 1110, a rotating part 1120, and a rotation support part 1130, thereby enabling the angle of illumination of the lighting unit 100 installed through a connection pipe 290 provided from the main body 200 to be adjusted.

The fixing part 1110 is made of a hollow pipe material, and includes a hollow tubular body 1110a that is coupled to the other end of the connection pipe 290 through which a first cable is wired and guided from the power supply 250 of the main body 200, and a cylindrical body 1110b that extends from the hollow tubular body 1110a and has an internal space therein.

The cylindrical body 1110b has a first opening 1112 formed in one surface thereof, and the first opening 1112 is open outward and has a substantially circular shape. The cylindrical body 1110b has a closed surface 1114 formed at the other surface thereof facing the first opening 1112. A withdrawal hole 1119 is preferably formed in the boundary area between the hollow tubular body 1110a and the cylindrical body 1110b to withdraw a first cable C1, which is wired and guided through the insides of the connection pipe 290 and hollow tubular body 1110a, to the internal space of the cylindrical body.

Although it is illustrated and described herein that the hollow tubular body 1110a is a circular tubular body and is connected to the connection pipe 290, the present invention is not limited thereto. The hollow tubular body 1110a may have various polygonal shapes identical to the cross-sectional shape of the connection pipe 290.

The rotating part 1120 includes a rotating body 1120a that is rotatably assembled while the inner surface thereof touches the outer surface of the cylindrical body. The rotating body 1120a may be a substantially semicircular sectional plate body having a coupler 1123 that is formed on the outer surface thereof corresponding to a second opening 1113 formed in the outer surface of the cylindrical body, wherein the coupler 1123 is coupled with an LED light 1103.

The coupler 1123 preferably has an extension rib 1123a extending outward to increase the coupling force with a connection pipe 119 provided from the casing 110 of the lighting unit 110 when the coupler 1123 is coupled with the lighting unit 110.

Although the first and second openings 1112 and 1113 are illustrated and described herein as being interconnected, the present invention is not limited thereto. The first and second openings 1112 and 1113 may be independently formed in one surface and the outer surface of the cylindrical body 1110b, respectively.

The rotation support part 1130 includes first and second support plates 1131 and 1132 that are assembled to both left and right sides of the rotating body 1120a to be restricted by the cylindrical body 1110b, thereby enabling the rotational movement of the rotating body 1120a coupled with the connection pipe 119 of the lighting unit 100 to be supported relative to the cylindrical body 1110b extending from the hollow tubular body coupled with the connection pipe.

The first and second support plates 1131 and 1132 may be substantially disk plate bodies that are respectively assembled to both edges of the rotating body 1120a by a plurality of first and second fastening members 1135a and 1135b so as to respectively cover the first opening 1112 formed in one side of the cylindrical body 1110b and the closed surface 1114 formed at the other side thereof.

In this case, it is preferable that the rotating body 1120a have a plurality of bosses 1139 protruding outward to increase the coupling force with the first and second fastening members 1135a and 1135b, and each of the first and second support plates 1131 and 1132 have a plurality of protrusion pieces 1139a formed at the outer edges thereof corresponding to the bosses 1139, the respective protrusion pieces 1139a having coupling holes coupled with associated ones of the first and second fastening members.

The respective first and second support plates 1131 and 1132 have first and second arc guide holes 1133 and 1134 that are open in an arc shape so that first and second fixing shafts provided at both edges of the cylindrical body 1110b are disposed in the first and second arc guide holes 1133 and 1134.

Here, one 1131a of the first and second fixing shafts is a screw member for rotation guide, which is disposed in the associated arc guide hole to be screwed to a coupling hole 1115 formed at the outer edge of the first opening 1112 formed in one side of the cylindrical body. The coupling hole 1115 is preferably formed in a thick portion 1112a that is thick in section, compared to other portions thereof, to increase the coupling force with the screw member for rotation guide.

The other 1132a of the first and second fixing shafts may be a pin member for rotation guide and position check, which protrudes from the closed surface 1114 formed at the other side of the cylindrical body and is disposed in the associated arc guide hole. An indicator 1132b may be provided at the outer edge of the arc guide hole to check a change in position of the pin member for rotation guide and position check and check an angle of illumination of the LED light according to the rotation of the rotating body.

Although the indicator 1132b is illustrated and described as being a protrusion jaw protruding from the outer surface of the second support plate rotating relative to the second fixing shaft fixed during the rotation of the rotating body, the present invention is not limited thereto. The indicator 1132b may be a scale member for illumination angle check, which is provided along the second arc guide hole.

The closed surface 1114 of the cylindrical body 1110b is formed with a recessed shaft hole 1116 for assembly of a rotation support shaft 1136 coupled through a central hole 1136a formed at the center of the second support plate 1132. The rotation support shaft 1136 may be a screw member screwed to a female thread formed on the inner surface of the shaft hole, the present invention is not limited thereto. The rotation support shaft 1136 may be a shaft member, the end of which is fixedly inserted into the shaft hole, and about which the second support plate rotates.

Thus, the first opening 1112 formed in one side of the cylindrical body 1110b is covered by the first support plate 1131, and the closed surface 1114 formed at the other side of the cylindrical body 1110b is covered by the second support plate 1132.

In this state, the rotating body 1120a coupled to the LED light 1103 may be conveniently adjusted to vary the angle of illumination of the LED light 1103 while rotating about the rotation support shaft 1136 along the outer surface of the cylindrical body by the first and second arc guide holes 1131 and 1134 formed in the second support plates 1131 and 1132 and the first and second fixing shafts 1131a and 1132a disposed therein. In addition, the angle of illumination of the LED light 1103 may be easily and accurately checked with the naked eye by the indicator 1132b.

Meanwhile, a junction part 1140 may be provided in the internal space of the cylindrical body 1110b to electrically connect the end of a first cable C1, which is connected to the power supply 250 of the main body 200, to the end of a second cable C2 which is electrically connected to the substrates of the lighting unit 100.

The junction part 1140 includes a base plate 1141 having a junction substrate 1142 mounted thereon, and the end of the first cable C1 is electrically connected to the end of the second cable C2 on the junction substrate 1142.

Although the respective ends of the first and second cables C1 and C2 are illustrated and described as being connected to the terminals of the junction substrate having a pattern circuit printed thereon in a soldering manner, the present invention is not limited thereto. The respective ends of the first and second cables C1 and C2 may be connected to connectors included in the junction substrate.

The base plate 1141 may include at least one electric component 143 including an overcurrent circuit for prevention of overcurrent.

The base plate 1141 may be an integral plate that extends outward from the inner surface of the cylindrical body, or a detachable plate that is detachably assembled in such a manner that one end thereof is inserted into an assembly groove 1144a of an assembly jaw 1144 formed on the inner surface of the cylindrical body.

Thus, when the first support plate 1131 corresponding to the first opening 1112 of the cylindrical body is decoupled from the rotating body 1120a at the time of maintenance work for replacement or repair of the lighting unit 100, the internal space of the cylindrical body may be opened by the second support plate 1132 such that the junction part 1140 is exposed to the outside in the state in which the cylindrical body is assembled to the rotating body. Therefore, the maintenance work for replacement or repair of the lighting unit 100 and the cables can be conveniently performed in the state in which the cylindrical body and the rotating body are not separated from each other.

Although the present invention has been described with respect to the illustrative embodiments, it will be apparent to those skilled in the art that various variations and modifications may be made without departing from the spirit and scope of the invention as defined in the following claims.

### INDUSTRIAL APPLICABILITY

In accordance with the present invention, it is possible to manufacture a camera-integrated LED lighting device that includes a main body having a lighting unit coupled to the front surface thereof while a camera is exposed at the bottom surface of the main body, and a light shielding plate arranged at a portion of the bottom surface of the main body between the lighting unit and the camera to prevent light from being directly incident from the lighting unit to the camera, thereby enabling the image of an area to be captured to be prevented from interfering with the light emitted from the lighting unit.

## Claims

1. A camera-integrated LED lighting device comprising:
a main body (200) having a power supply (250) built therein, a portion of a camera module (210) being exposed at a bottom surface of the main body (200);
a lighting unit (100) coupled to a front surface of the main body (200) and comprising a plurality of LEDs to provide illumination by power supplied from the power supply (250) of the main body (200);
a connection unit (300) arranged on a rear surface of the main body (200) for coupling with a support or an arm; and
a camera protector (240) protruding from the bottom surface of the main body (200) along the circumference of the camera module (210).

2. The camera-integrated LED lighting device according to claim 1, further comprising a light shielding plate (220) arranged at a portion of the bottom surface of the main body (200) to block direct introduction of light from the lighting unit (100) to the camera module (210).

3. The camera-integrated LED lighting device according to claim 2, wherein the light shielding plate (220) is installed to be inclined such that its lower end is directed downward of the lighting unit (100) in a state in which an upper end of the light shielding plate (220) is coupled to the bottom surface of the main body (200).

4. The camera-integrated LED lighting device according to claim 3, the light shielding plate (220) is a reflective surface, a light absorption surface, or a solar cell.

5. The camera-integrated LED lighting device according to claim 1, wherein:
the main body (200) comprises a lower housing (280) that is open at its upper portion to accommodate the camera module (210), the power supply (250), a communication module (260), and a control circuit (270) therein; and
the lower housing (280) further comprises a hole (285) for insertion of the camera module (210), and a separator (211) covering the hole (285) when the camera module (210) is inserted into the hole (285).

6. The camera-integrated LED lighting device according to claim 1, wherein the lighting unit (100) comprises:
a casing (110) having a light outlet (111) and a plurality of seating surfaces formed on a portion of its inner surface;
a plurality of substrates (121 and 122) seated on the respective seating surfaces, the LEDs being mounted on each of the substrates (121 and 122); and
a plurality of radiation parts disposed at respective portions on an outer surface of the casing (110) corresponding to the seating surfaces positioned on the inner surface of the casing (110) so that each of the radiation parts dissipates heat from an associated one of the substrates (121 and 122).

7. The camera-integrated LED lighting device according to claim 1, further comprising a hinge unit (1000) connecting the lighting unit (100) to the main body (200), wherein the hinge unit (1000) comprises:
a fixing part comprising a hollow tubular body, coupled to a connection pipe (290) provided from the main body (200), and a cylindrical body having a first opening that is open at one surface thereof and a closed surface closed at the other surface thereof;
a rotating part comprising a rotating body rotatably assembled to an outer surface of the cylindrical body, the rotating body having a coupler formed on its outer surface corresponding to a second opening formed to be open at the outer surface of the cylindrical body, the coupler being coupled to a connection pipe (119) provided from the lighting unit (100), so that the rotating part is coupled to the lighting unit (100); and
a rotation support part comprising first and second support plates assembled to both edges of the rotating body to cover the closed surface and the first opening of the cylindrical body, the respective first and second support plates having first and second arc guide holes for arrangement of first and second fixing shafts provided at both edges of the cylindrical body 1110b, so that the rotation support part supports rotational movement of the rotating body relative to the cylindrical body.

8. The camera-integrated LED lighting device according to claim 7, wherein, in an internal space of the cylindrical body, an electric wire provided from the main body (200) is connected to an electric wire provided from the lighting unit (100).

9. The camera-integrated LED lighting device according to claim 7, wherein one of the first and second fixing shafts is a screw member for rotation guide, which is screwed to a coupling hole formed at an outer edge of the cylindrical body to be disposed in an associated one of the arc guide holes of the first and second support plates.

10. The camera-integrated LED lighting device according to claim 9, wherein the cylindrical body has a thick portion in which the coupling hole coupled with the fixing shaft is formed.

11. The camera-integrated LED lighting device according to claim 7, wherein the other of the first and second fixing shafts is a pin member for rotation guide and position check, which protrudes from the closed surface of the cylindrical body to be disposed in an associated one of the arc guide holes of the first and second support plates.

12. The camera-integrated LED lighting device according to claim 11, wherein an indicator is provided at an outer edge of the arc guide hole to check a change in position of the pin member for rotation guide and position check.

13. The camera-integrated LED lighting device according to claim 7, wherein the closed surface of the cylindrical body is formed with a recessed shaft hole for assembly of a rotation support shaft coupled through a central hole formed at the center of the second support plate.

14. The camera-integrated LED lighting device according to claim 7, wherein the coupler has an extension rib extending outward to increase coupling force with the connection pipe when the coupler is coupled with the lighting unit.

15. The camera-integrated LED lighting device according to claim 7, wherein:
a junction part is provided in an internal space of the cylindrical body to electrically connect a first cable provided from the main body (200) to a second cable provided from the lighting unit (100); and
the junction part comprises a base plate having a junction substrate mounted thereon, an end of the first cable being electrically connected to an end of the second cable on the junction substrate.

16. The camera-integrated LED lighting device according to claim 15, wherein the base plate is an integral plate extending outward from an inner surface of the cylindrical body, or a detachable plate assembled in such a manner that one end thereof is inserted into an assembly groove of an assembly jaw formed on the inner surface of the cylindrical body.
